# EUROPÄISCHE PATENTSCHRIFT

(11) **EP 0 889 683 B1**
(45) Veröffentlichungstag und Bekanntmachung des Hinweises auf die Patenterteilung: **12.05.2004**
(21) Anmeldenummer: 98111584.3
(22) Anmeldetag: 24.06.1998
(51) Int. Cl.: H05K 7/14, H05K 9/00

(54) **Verbindungselement zum elektrischen Verbinden einer Leiterplattenanschlusszone mit einem metallischen Gehäuseteil**
Device for electrically connecting of a board terminal area to a metallic casing part
Dispositif pour connecter électriquement une zone de contact sur une plaquette de circuit à une partie de boîtier métallique

(30) Priorität: 02.07.1997 DE 19728291
(43) Veröffentlichungstag der Anmeldung: 07.01.1999
(73) Patentinhaber: Conti Temic Microelectronic GmbH, 90411 Nürnberg (DE)
(72) Erfinder: Baur, Richard, 85276 Pfaffenhofen (DE); Fendt, Günter, 86529 Schrobenhausen (DE); Wierzioch, Klaus, 86529 Schrobenhausen (DE)

(56) Entgegenhaltungen:
- US-A- 5 500 789
- US-A- 5 519 169
- PATENT ABSTRACTS OF JAPAN vol. 096, no. 007, 31. Juli 1996 & JP 08 069826 A (SANKEN ELECTRIC CO LTD), 12. März 1996

## Beschreibung

Die Erfindung betrifft ein Verbindungselement zum elektrischen Verbinden einer Leiterplattenanschlußzone mit einem metallischen Gehäuseteil über ein kraftschlüssiges metallisches Teil gemäß dem Oberbegriff des Patentanspruchs 1. Die Erfindung betrifft weiterhin ein entsprechendes Verfahren.

Bisher werden in der Praxis elektrische Verbindungen zwischen einer Leiterplattenanschlußzone und einem metallischen Gehäuseteil, insbesondere zum Anschluß an die elektrische Masse über das Gehäuse, meist direkt über das kraftschlüssige metallische Teil, meist eine Schraube oder ein Niet, realisiert, indem die elektrische Leiterplattenanschlußzone an bzw. auf das metallische Gehäuseteil aufgepreßt werden. Da aber die Leiterplatten aus Kunststoff sind, verformen sich diese unter der Wirkung der Anpreßkraft im Alterungsprozeß, so daß sich die elektrische Verbindung in ihrer Güte nicht über die Produktlebensdauer hinweg sichergestellt werden kann. Aus diesem Grunde wurde bisher zur Gewährleistung einer sicheren Massekontaktierung über die Lebensdauer eine separate Masse über einen Pin im Anschlußstecker geführt. Außerhalb der Baugruppe wurde dann durch Abgriff vom Anschlußstecker die Masseleitung mittels eines Kabelschuhs direkt an die metallische Gehäuseteilmasse kontaktiert, was jedoch recht aufwendig ist, da ein zusätzlicher Pin im Anschlußstecker, ein Abgriffelement, eine äußere Masseleitung sowie ein Kabelschuh benötigt und montiert werden müssen.

Bei einer anderen Lösung weist die Leiterplatte im Bereich der Leiterplattenanschlußzone beidseitig Metallisierungen auf, die durch eine Durchkontaktierung durch die Leiterplatte hindurch miteinander verbunden sind, wie es bspw. aus der US 4,927,367 entnommen werden kann. Auch hier ist eine Verformung der Leiterplatte über die Lebensdauer hinweg nicht auszuschließen. Andere Masseverbindungen sind aus der DE 296 03 747 U1 sowie, als elastische Federn ohne mechanisch tragende Funktion ausgeführt, aus der US 5,138,529 und der US 3,066,367 bekannt.

Hervorzuheben ist die JP 08069826, aus der ein Verbindungselement entnommen werden kann, welches eine Grundfläche und einen Kontaktstift aufweist, der mittels Löten in einer Leiterplattenöffnung befestigt wird. Die zuvor noch von der Leiterplatte abstehende Grundfläche mit einer buchsenförmigen Ausformung zur Durchführung des kraftschlüssigen Teils wird nach dem Verlöten auf die Leiterplatte abgebogen. Ziel der zuvor von der Leiterplatte abstehenden Grundfläche ist es, Lötmediumspuren, die sich sonst an dem Rand der buchsenförmigen Ausformung beim Schwalllöten absetzen, zu vermeiden. Die Montage einer Leiterplatte mit einem derartigen Verbindungselement an einem Gehäuseteil ist aufwendig, da das Verbindungselement mit der zunächst abstehenden Grund-fläche erst mit dem Kontaktstift an der Leiterplatte befestigt, nachfolgend auf die Leiterplatte abgebogen und dann mit dem kraftschlüssigen Teil endgültig fixiert werden muß. Es muß dabei genau positioniert werden, damit nachfolgend die buchsenförmige Ausformung genau über der Leiterplattenöffnung steht. Um die Toleranzen im Abstand zwischen Kontaktstift und buchsenförmiger Ausformung ausgleichen zu können, muß die Öffnung in der Leiterplatte größer sein. Das laterale Arbeitsvermögen des Aufbaus ist schlecht und müßte vom Gehäuse ausgeglichen werden. Die Berührungsfläche der buchsenförmigen Ausformung zum Gehäuseteil ist auf den Rand beschränkt und daher bei mechanischen Belastungen ungünstig. Ein Teil der Kräfte wird sich wiederum auf die sich zwischen der Grundfläche und dem Gehäuseteil befindliche Leiterplatte verteilen.

Aufgabe der Erfindung ist es, eine möglichst einfache elektrische Verbindung zwischen der Leiterplatte und dem Gehäuse zu schaffen, bei der diese Verbindung mechanisch stabil und über die geforderte Produktlebensdauer hinweg sichergestellt werden kann.

Diese Aufgabe wird durch die Merkmale der unabhängigen Patentansprüche gelöst. Vorteilhafte Weiterbildungen sind den Unteransprüchen zu entnehmen.

Das erfindungsgemäße Verbindungselement weist eine Grundfläche mit einer Öffnung auf, durch welche das kraftschlüssige Teil zum Gehäuse hin eingebracht wird. U-förmig von der Grundfläche abgewinkelt ist zumindest ein die Verbindung zur Leiterplatte herstellender Kontaktstift vorgesehen. Dieser ist bspw. aus dem gleichen Material, wie die Grundfläche und senkrecht auf dieser angeordnet. In der Leiterplattenanschlußzone ist eine entsprechende Öffnung vorgesehen, in welche der Kontaktstift eingeführt und dort mechanisch und elektrisch leitend mit der Leiterplatte verbunden wird.

Die Grundfläche aus elektrisch leitendem Material, vorzugsweise Metall, ist dabei in der Lage, die mechanischen Belastungen an der kraftschlüssigen Verbindung besser aufzunehmen, als die Leiterplatte. Die Leiterplatte ist ihrerseits über den bzw. die Kontaktstifte an der Grundfläche befestigt und elektrisch verbunden.

Da Leiterplattenanschlußzonen bereits generell metallisiert sind, ist bereits mit dem Einbringen des Kontaktstiftes eine elektrische Verbindung geschaffen, die jedoch durch Verlöten des Kontaktstiftes verbessert werden kann (Anspruch 4).

Die Arretierung des Kontaktstiftes in der Öffnung der Leiterplattenanschlußzone kann alternativ oder zusätzlich zum Verlöten durch Presspassung erfolgen. Gemäß Anspruch 5 ist der Kontaktstift durch eine Preßpassung in der Öffnung der Leiterplattenanschlußzone verankert. Dies kann gemäß Anspruch 6 vorzugsweise durch einen in seinem Außendurchmesser federnden Kontaktstift realisiert werden, der gemäß Anspruch 7 bevorzugt durch wenigstens eine axiale Feder-Nut unter Überwindung einer Rückstellkraft zusammengepreßt werden kann. Nach dem Einbringen des Kontaktstiftes in die Öffnung der Leiterplattenanschlußzone führt die Rückstellkraft zu einer ergänzenden Arretierung, da sie an die Innenfläche der Öffnung drückt und so die Preßpassung verstärkt.

Zur Verbesserung der Verteilung der Kräfte sind gemäß Anspruch 8 mindestens zwei Kontaktstifte vorgesehen. Natürlich sind auch noch mehr Kontaktstifte, bspw. eine Drei- oder Vier-Punkt-Arretierung, bevorzugt geeignet, die bei der Montage bspw. durch das Eindrehen einer Schraube hervorgerufenen Drehmomente, oder die durch Bewegungen, Erschütterungen oder durch die die Leiterplatte tragende Funktion hervorgerufenen Kräfte aufzunehmen und gleichmäßig zu verteilen, so daß eine mechansiche Überlastung der Verbindung Kontaktstift-Leiterplattenöffnung vermieden wird.

Wie durch Anspruch 9 gelehrt wird, ist insbesondere eine Grundfläche aus Kupferberyllium entsprechend formbeständig, so daß auch über die Produktlebensdauer hinweg eine sichere elektrische Verbindung gewährleistet wird.

Für das Verfahren zum elektrischen Verbinden erweist es als vorteilhaft, zunächst das Verbindungselement über den bzw. die u-förmigen Kontaktstifte an die Leiterplatte zu montieren. Die Leiterplatte ist danach weiter gut handhabbar, kann bspw. weiterhin gut bestückt und nachfolgend an das Gehäuseteil mittels des kraftschlüssigen Teils montiert, bspw. verschraubt oder vernietet werden. Besonders vorteilhaft ist, wenn der bzw. die Kontaktstifte zusammen mit den elektrischen Bauteilen auf der Leiterplatte in einem Arbeitsgang, bspw. durch Schwalllöten verlötet werden. Gegenüber herkömmlichen durch Löten zusätzlich gesicherten Verbindungen spart man hierbei einen erheblichen, mit entsprechenden Kosten verbundenen Arbeitsgang des nachträglichen Verlötens vom kraftschlüssigen Teil mit der Leiterplattenanschlußzone ein. Durch diese Einsparungen werden die Kosten für das zusätzliche, erfindungsgemäße Verbindungselement bei weitem kompensiert.

Die Erfindung wird nachfolgend anhand von Ausführungsbeispielen und Figuren näher erläutert.

Kurze Beschreibung der Figuren:
- Figur 1: Schnitt durch eine Baugruppe, bei der eine Leiterplatte mittels des Verbindungselements an ein metallisches Gehäuseteil geschraubt wurde
- Figur 2: Detailansicht des Verbindungselements gemäß Figur 1
- Figur 3: Verbindungselement, bei dem die Kontaktstifte als Spannstifte ausgeführt sind und eine axiale Federnut aufweisen
- Figur 4: Skizze des Wirkprinzips bei Verbindungselementen, bei denen die Grundfläche zusätzlich die kraftschlüssige Verbindung sichert oder verstärkt.

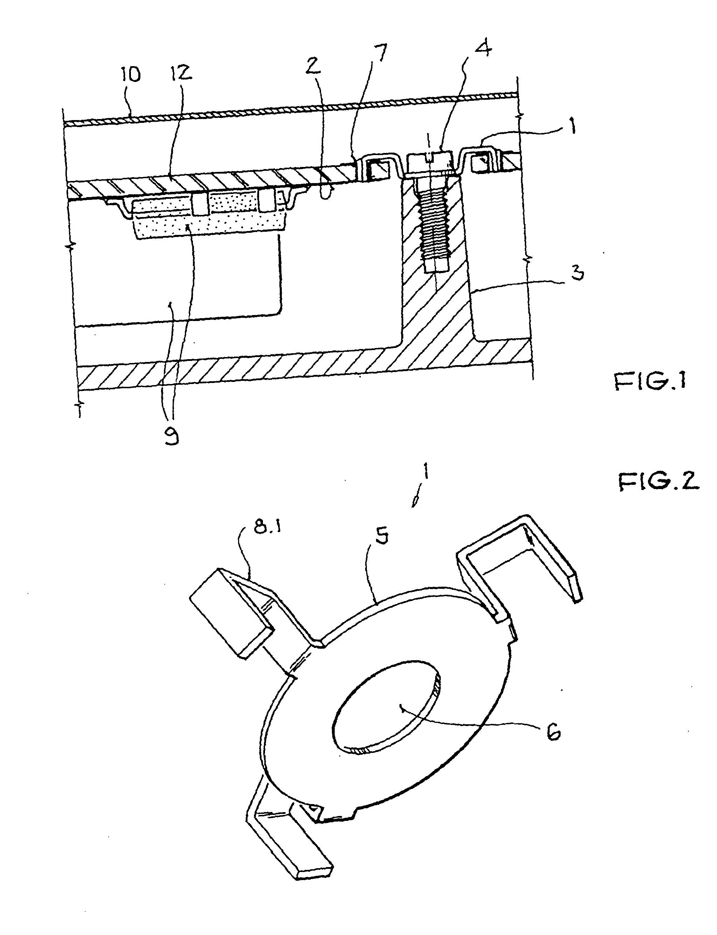

Figur 1 zeigt eine Baugruppe, bei der innerhalb eines Gehäuses, bestehend aus einem Gehäusedeckel 10 und einem metallischen Gehäuseunterteil 3, eine Leiterplatte 12 angeordnet ist. Auf der Leiterplatte 12 befinden sich elektronische Bauelemente 9, welche mit Leitbahnen auf der Leiterplattenoberseite entsprechend der elektrischen Funktion miteinander verbunden sind. Die Leiterplatte 12 weist weiterhin eine in bekannter Weise metallisierte Leiterplattenanschlußzone 2 auf, in der sich eine Öffnung 7 befindet. Diese Öffnung 7 ist vorzugsweise ebenfalls an ihrer Mantelfläche metallisiert, wie dies bereits für Durchsteckbauelemente oder zweiseitige Leiterplattenanordnungen bekannt ist. In diese Öffnung 7 der Leiterplatte 12 ist das Verbindungselement 1 eingebracht. Zwischen der Öffnung 7 der Leiterplatte 12 und dem in Figur 2 noch im Detail dargestellten Kontaktstift 8.1 des Verbindungselements 1 besteht eine Verbindung durch Presspassung oder Löten. In diesem Ausführungsbeispiel ist eine runde Öffnung 7 in der Leiterplatte vorgesehen, deren Durchmesser entsprechend der Breite der rechteckigen Kontaktstifte (vergleiche 8.1 in Figur 2) zu einem Verhaken der rechteckigen Kanten des Kontaktstiftes in der Metallisierung der Öffnung 7 führt. Die Kontaktstifte 8.1 sind in diesem Ausführungsbeispiel einstückig aus dem gleichen Material wie die Grundfläche gestaltet und werden durch Biegen derart geformt, daß sie die Dicke der Leiterplatte entsprechend ausgleichen und die Grundfläche 5 des Verbindungselements mit der Leiterplattenunterseite abschließt. Durch die Öffnung 6 in der Grundfläche 5 des Verbindungselements 1 (vergleiche auch Figur 2) ist das kraftschlüssige metallische Teil 4 zum metallischen Gehäuseteil 3 hin befestigt. In diesem gezeigten Ausführungsbeispiel ist die kraftschlüssige Verbindung als Schraubverbindung ausgestaltet und besteht aus der Schraube 4, welche die Grundfläche 5 mittels des Gewindes im metallischen Gehäuseteil 3 an diesem preßt. Die elektrische Verbindung besteht zwischen den meist als metallischen Leitbahnen ausgeführten Leiterplattenanschlußzone 2 mit der Öffnung 7 über die Kontaktstifte 8 und die Grundfläche 5 zum kraftschlüssigen Teil 4 bzw. direkt zum metallischen Gehäuseteil 3.

In Figur 2 ist noch mal eine Detailansicht des bereits im Zusammenhang mit Figur 1 beschriebenen Verbindungselements 1 dargestellt. An der Grundfläche 5 sind in diesem Ausführungsbeispiel 3 Kontaktstifte vorgesehen. Neben dem für den elektrischen Kontakt erforderlichen ersten Kontaktstift dienen die weiteren Kontaktstifte der gleichmäßigeren Verteilung der mechanischen Belastung zwischen Leiterplatte und Gehäuse. Die symmetrische 3-Punkt-Auflage wird diesem beispielsweise sehr gut gerecht. Die Kontaktstifte sind in diesem Ausführungsbeispiel nach einem kurzen Ansatzstück zur Grundfläche 5 hin quasi senkrecht zu dieser angeordnet. Durch die insgesamt 3 Biegungen in den Kontaktstiften ergibt sich eine gewisse Elastizität der Anordnung, womit Fertigungstoleranzen ausgeglichen und mechanische Belastungen kompensiert werden können.

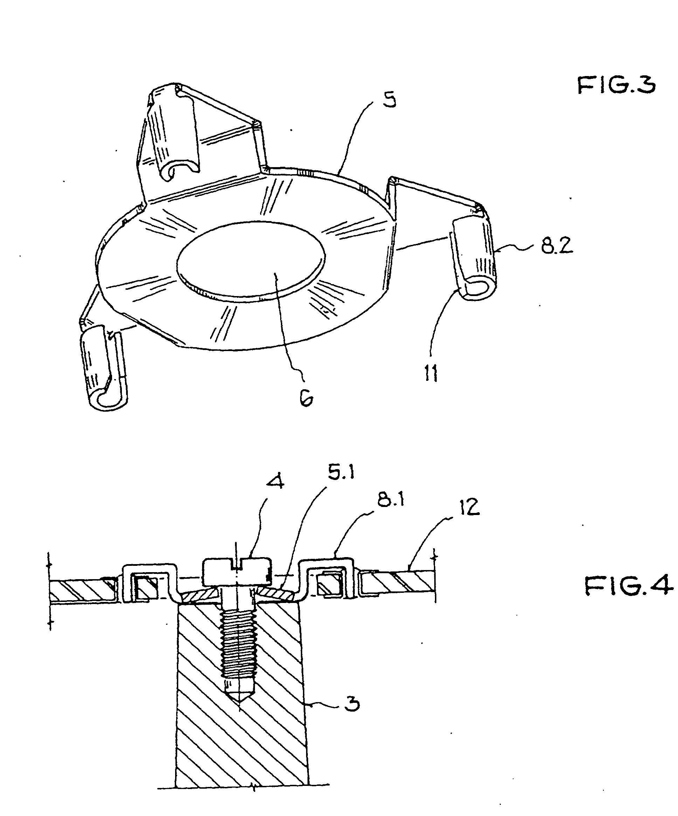

Figur 3 zeigt ein anderes Ausführungsbeispiel eines Verbindungselements, bei der die kreisrunde Grundfläche 5 zunächst in Form eines Dreieckes verlängert und in den Ecken jeweils ein Kontaktstift 8.2 angeordnet ist, der als Spannstift ausgeführt ist. Jeder der Kontaktstifte 8.2 weist eine axiale Federnut 11 auf, durch welche der Außendurchmesser des Kontaktstiftes durch Zusammenpressen in die Öffnung der Leiterplatte eingeschoben wird und sich danach eine Rückstellkraft einseitig an die Leiterplattenöffnung 7 ausbildet.

In Figur 4 ist nun ein ergänzendes Wirkprinzip dargestellt, welches durch entsprechende Ausgestaltung der Grundfläche 5 als zusätzliches Sicherungselement der kraftschlüssigen Verbindung zwischen kraftschlüssigen Teil 4 und metallischen Gehäuseteil 3 erzielt werden kann. So sind beispielsweise für Schraubverbindungen zum Sichern Tellerfedern oder Zahnkränze bekannt. In Figur 4 ist am Beispiel einer tellerfederähnlichen Ausgestaltung der Grundfläche 5.1, die sich ausbildende Rückstellkraft visualisiert, welche die kraftschlüssige Verbindung verstärkt. Aus dem Stand der Technik sind weitere Sicherungsmöglichkeiten für Schraubverbindungen, wie z. B. Wellenprofile der Scheiben oder Kerbscheiben bekannt. Durch entsprechende Ausgestaltung der Grundfläche 5 können somit ergänzende Sicherungsinstrumente eingebaut werden. Ein solcher Einbau läßt sich sehr einfach in das Verbindungselement integrieren und kann so erforderlichenfalls entsprechend zusätzliche Arbeitsgänge für eine getrennte Sicherung der kraftschlüssigen Verbindung ersparen. Der Montageaufwand wird dadurch nochmals reduziert.

Neben den dargestellten Schraubverbindungen können natürlich auch Nietverbindungen oder ähnliche die kraftschlüssige Verbindung zwischen Verbindungselement und Gehäuseteil realisieren.

## Patentansprüche

1. Verbindungselement (1) zum elektrischen Verbinden einer Leiterplattenanschlußzone (2) mit einem metallischen Gehäuseteil (3) über ein kraftschlüssiges metallisches Teil (4), wobei das Verbindungselement (1)
a) eine elektrisch leitfähige Grundfläche (5) mit einer Öffnung (6) zum Einbringen des kraftschlüssigen Teils (4) aufweist,
b) mindestens einen Kontaktstift (8.1, 8.2) zur Befestigung des Verbindungselements (1) in einer Öffnung (7) der Leiterplattenanschlußzone (2) aufweist,
**dadurch gekennzeichnet, dass**
c) der mindestens eine Kontaktstift (8.1, 8.2) u-förmig von der Grundfläche (5) abgewinkelt ist.

2. Verbindungselement nach Anspruch 1, **dadurch gekennzeichnet, dass** die Grundfläche (5) kleiner ist als eine zweite Öffnung in der Leiterplatte (12) und dass der mindestens eine Kontaktstift (8.1, 8.2) so ausgestaltet ist, dass beim Befestigen des Verbindungselements (1) an der Leiterplatte die Grundfläche (5) in der zweiten Öffnung angeordnet wird.

3. Verbindungselement nach Anspruch 2, **dadurch gekennzeichnet, dass** die Grundfläche (5) derart verspannbar ausgebildet ist, dass sie beim Kraftschluß zwischen dem kraftschlüssigen Teil (4) und dem metallischen Gehäuseteil (3) tellerfederförmig verspannt wird.

4. Verbindungselement nach einem der vorangehenden Ansprüche,
**dadurch gekennzeichnet, dass**
der mindestens eine Kontaktstift (8.1,8.2) mit der Leiterplattenanschlußzone (2) verlötbar ist.

5. Verbindungselement nach einem der vorangehenden Ansprüche,
**dadurch gekennzeichnet, dass**
der mindestens eine Kontaktstift (8.1, 8.2) durch Preßpassung in der Öffnung (7) der Leiterplattenanschlußzone (2) arretierbar ist.

6. Verbindungselement nach Anspruch 5, **dadurch gekennzeichnet, dass** der mindestens eine Kontaktstift (8.2) buchsenförmig und im Durchmesser fedemd gestaltet ist.

7. Verbindungselement nach Anspruch 6, **dadurch gekennzeichnet, dass** der mindestens eine Kontaktstift (8.2) zumindest eine axiale Feder-Nut (11) aufweist und der Außendurchmesser des Kontaktstiftes (8.2) durch Zusammenpressen dieser unter Überwindung einer Rückstellkraft reduzierbar ist.

8. Verbindungselement nach einem der vorangehenden Ansprüche,
**dadurch gekennzeichnet, dass**
mindestens zwei Kontaktstifte (8.1, 8.2) vorgesehen sind.

9. Verbindungselement nach einem der vorangehenden Ansprüche,
**dadurch gekennzeichnet, dass**
die Grundfläche (5) aus einem formbeständigen metallischen Material ist, vorzugsweise aus Kupferberyllium oder Bronzelegierungen.

10. Verfahren zum elektrischen Verbinden einer Leiterplattenanschlußzone (2) mit einem metallischen Gehäuseteil (3) über ein kraftschlüssiges metallisches Teil (4) und ein Verbindungselement (1) mit einer elektrisch leitfähigen Grundfläche (5) und mindestens einem u-förmig von der Grundfläche (5) abgewinkelten Kontaktstift (8.1,8.2), wobei
a) der mindestens eine Kontaktstift (8.1, 8.2) in einer Öffnung (7) der Leiterplattenanschlußzone (2) befestigt wird,
b) das kraftschlüssige Teil (4) in eine Öffnung (6) der Grundfläche (5) eingebracht wird, und
c) das kraftschlüssige Teil (4) mit dem metallischen Gehäuseteil (3) kraftschlüssig verbunden wird.

11. Verfahren nach Anspruch 10, **dadurch gekennzeichnet, dass**
die Grundfläche (5) beim Kraftschluß zwischen dem kraftschlüssigen Teil (4) und dem metallischen Gehäuseteil (3) tellerfederförmig verspannt wird.

12. Verfahren nach Anspruch 10 oder 11, **dadurch gekennzeichnet, dass**
der mindestens eine Kontaktstift (8.1,8.2) mit der Leiterplattenanschlußzone (2) verlötet wird.

13. Verfahren nach einem der Ansprüche 10 bis 12,
**dadurch gekennzeichnet, dass**
der mindestens eine Kontaktstift (8.1, 8.2) durch Preßpassung in der Öffnung (7) der Leiterplattenanschlußzone (2) arretiert wird.

14. Verfahren nach Anspruch 13, **dadurch gekennzeichnet, dass**
der Außendurchmesser des mindestens einen Kontaktstiftes (8.2) durch Zusammenpressen einer axiale Feder-Nut (11) unter Überwindung einer Rückstellkraft reduziert wird

15. Verfahren nach einem der Ansprüche 10 bis 14,
**dadurch gekennzeichnet, dass**
a) zunächst das Verbindungselement (1) an die Leiterplatte montiert wird, indem der mindestens eine Kontaktstift (8.1,8.2) befestigt wird, und
b) danach die Leiterplatte mit dem montierten Verbindungselement (1) an das metallische Gehäuseteil (3) montiert wird, indem das kraftschlüssige Teil (4) in die Öffnung (6) der Grundfläche (5) eingebracht und mit dem metallischen Gehäuseteil (3) kraftschlüssig verbunden wird.

16. Verfahren nach einem der Ansprüche 10 bis 15,
**dadurch gekennzeichnet, dass**
der mindestens eine Kontaktstift (8.1, 8.2) zusammen mit elektrischen Bauteilen auf der Leiterplatte in einem Arbeitsgang verlötet wird.

## Claims

1. A connecting element (1) for electrically connecting the terminal zone (2) of a circuit board to a metallic housing part (3) via a non-positive metallic part (4), wherein the connecting element (1) comprises
a) an electrically conductive base surface (5) having an opening (6) for the insertion of the non-positive part (4),
b) at least one contact pin (8.1, 8.2) for fixing the connecting element (1) in an opening (7) in the terminal zone (2) of the circuit board,
**characterised in that**
c) said at least one contact pin (8.1, 8.2) is bent up in the form of a U from the base surface (5).

2. A connecting element in accordance with Claim 1,
**characterised in that**
the base surface (5) is smaller than a second opening in the circuit board (12), and **in that** said at least one contact pin (8.1, 8.2) is arranged in such a manner that the base surface (5) is located in the second opening when the connecting element (1) is fixed to the circuit board.

3. A connecting element in accordance with Claim 2,
**characterised in that**
the base surface (5) is deformable in such a way that it will be deformed in the manner of a cup spring by the non-positive connection between the non-positive part (4) and the metallic housing part (3).

4. A connecting element in accordance with any of the preceding Claims,
**characterised in that**
said at least one contact pin (8.1, 8.2) is arranged to be soldered to the terminal zone (2) of the circuit board.

5. A connecting element in accordance with any of the preceding Claims,
**characterised in that**
said at least one contact pin (8.1, 8.2) is arranged to be retained in the opening (7) in the terminal zone (2) of the circuit board by means of a press fit.

6. A connecting element in accordance with Claim 5,
**characterised in that**
said at least one contact pin (8.2) is sleeve shaped and the diameter thereof is springy.

7. A connecting element in accordance with Claim 6,
**characterised in that**
said at least one contact pin (8.2) comprises at least one springy axial slit (11) and the outer diameter of the contact pin (8.2) is adapted to be reduced by squeezing it together such as to overcome the restoring force thereof.

8. A connecting element in accordance with any of the preceding Claims,
**characterised in that**
at least two contact pins (8.1, 8.2) are provided.

9. A connecting element in accordance with any of the preceding Claims,
**characterised in that**
the base surface (5) consists of a metallic material that is able to retain its shape, preferably, of copper beryllium or bronze alloys.

10. A method for electrically connecting the terminal zone (2) of a circuit board to a metallic housing part (3) via a non-positive metallic part (4) and a connecting element (1) having an electrically conductive base surface (5) and at least one U-shaped contact pin (8.1, 8.2) bent up from the base surface (5), wherein
a) said at least one contact pin (8.1, 8.2) is fixed in an opening (7) in the terminal zone (2) of the circuit board,
b) the non-positive part (4) is inserted into an opening (6) in the base surface (5), and
c) the non-positive part (4) is connected to the metallic housing part (3) by a non-positive connection.

11. A method in accordance with Claim 10,
c**haracterised in that**
the base surface (5) is deformed in the manner of a cup spring by the force connection between the non-positive part (4) and the metallic housing part (3).

12. A method in accordance with Claim 10 or 11,
**characterised in that**
said at least one contact pin (8.1, 8.2) is soldered to the terminal zone (2) of the circuit board.

13. A method in accordance with any of the Claims 10 to 12,
**characterised in that**
said at least one contact pin (8.1, 8.2) is retained in the opening (7) in the terminal zone (2) of the circuit board by means of a press fit.

14. A method in accordance with Claim 13,
**characterised in that**
the outer diameter of said at least one contact pin (8.2) is reduced by squeezing a springy axial slit (11) together such as to overcome a restoring force.

15. A method in accordance with any of the Claims 10 to 14,
**characterised in that**
a) the connecting element (1) is initially mounted on the circuit board by fixing said at least one contact pin (8.1, 8.2), and
b) the circuit board together with the mounted connecting element (1) is then mounted on the metallic housing part (3) by inserting the non-positive part (4) into the opening (6) in the base surface (5) and is connected to the metallic housing part (3) by a non-positive connection.

16. A method in accordance with any of the Claims 10 to 15,
**characterised in that**
said at least one contact pin (8.1, 8.2), together with electrical components on the circuit board, is soldered in a single operation.

## Revendications

1. Elément de connexion (1) en vue de la connexion électrique d'une zone de contact (2) de plaquette de circuit à une partie métallique de boîtier (3) par l'intermédiaire d'une pièce métallique de solidarisation (4), l'élément de connexion (1) comportant:
a) une surface de base (5) électriquement conductrice avec une ouverture (6) pour l'introduction de la pièce de solidarisation (4),
b) au moins une tige de contact (8;1, 8.2) en vue de la fixation de l'élément de connexion (1) dans une ouverture (7) de la zone de contact (2) de la plaquette de circuit ,
**caractérisé en ce que**
c) la au moins une tige de contact (8.1,8.2) est pliée en forme de U par rapport à la surface de base (5).

2. Elément de connexion selon la revendication 1, **caractérisé en ce que** la surface de base (5) est plus petite qu'une seconde ouverture dans la plaquette de circuit (12) et **en ce que** la au moins une tige de contact (8.1, 8.2) est configurée de sorte que lors de la fixation de l'élément de connexion (1) sur la plaquette de circuit, la surface de base (5) est disposée dans la secondé ouverture.

3. Elément de connexion selon la revendication 2, **caractérisé en ce que** la surface de base (5) est réalisée déformable de telle sorte qu'elle soit déformée en forme de ressort à disque lors de la solidarisation entre la pièce de solidarisation (4) et la partie métallique du boîtier (3).

4. Elément de connexion selon une des revendications précédentes, **caractérisé en ce qu'**au moins une tige de contact (8.1,8.2) peut être soudée à la zone de contact (2) de la plaquette de circuit.

5. Elément de connexion selon une des revendications précédentes, **caractérisé en ce que** la au moins une tige de contact (8.1;8.2) peut être bloquée par ajustement à la presse dans l'ouverture (7) de la zone de contact (2) de la plaquette de circuit.

6. Elément de connexion selon la revendication 5, **caractérisé en ce qu'**au moins une tige de contact (8.2) est réalisée en forme de douille et à diamètre élastique.

7. Elément de connexion selon la revendication 6, **caractérisé en ce qu'**au moins une tige de contact (8.2) présente au moins une gorge élastique axiale (11) et le diamètre extérieur de la tige de contact (8.2) peut être réduit par compression de celle-ci en surmontant une force de rappel.

8. Elément de connexion selon une des revendications précédentes, **caractérisé en ce qu'**au moins deux tiges de contact (8.1,8.2) sont prévues.

9. Elément de connexion selon une des revendications précédentes, **caractérisé en ce que** la surface de base (5) est en un matériau métallique de forme stable de préférence en cuivre au béryllium ou en alliages de bronze.

10. Procédé de connexion électrique d'une zone de contact (2) d'une plaquette de circuit à une partie métallique du boîtier (3) par l'intermédiaire d'une pièce métallique de solidarisation (4) et un élément de connexion (1) à une surface de base électriquement conductrice (5) et au moins une tige de contact (8.1,8.2) pliée en forme de U de la surface de base (5),
a) la au moins une tige de contact (8.1,8.2) étant fixée dans une ouverture (7) de la zone de contact (2) de la plaquette de circuit,
b) la pièce de solidarisation (4) étant introduite dans une ouverture (6) de la surface de base (5), et
c) la pièce de solidarisation (4) étant reliée par solidarisation à la partie métallique du boîtier (3).

11. Procédé selon la revendication 10, **caractérisé en ce que** la surface de base (5) est déformée en forme de ressort à disque lors de la solidarisation entre la pièce de solidarisation (4) et la partie métallique du boîtier (3).

12. Procédé selon la revendication 10 ou 11, **caractérisé en ce qu'**au moins une tige de contact (8.1,8.2) est soudée à la zone de contact (2) de la plaquette de circuit.

13. Procédé selon une des revendications 10 à 12, **caractérisé en ce qu'**au moins une tige de contact (8.1,8.2) est bloquée par ajustement par pression dans l'ouverture (7) de la zone de contact (2) de la plaquette de circuit.

14. Procédé selon la revendication 13, **caractérisé en ce que** le diamètre extérieur d'au moins une tige de contact (8.2) est réduit par compression d'une rainure élastique axiale (11) en surmontant une force de rappel.

15. Procédé selon des revendications 1 à 14, **caractérisé en ce que**
a) tout d'abord l'élément de connexion (1) est monté sur la plaquette de circuit, dans laquelle est fixée la au moins une tige de contact (8.1,8.2), et
b) ensuite la plaquette de circuit avec l'élément de connexion mis en place (1) est montée sur la partie métallique (3) du boîtier, dans laquelle la partie de solidarisation (4) est introduite dans l'ouverture (6) de la surface de base (5) et est rendue solidaire de la partie métallique (3) du boîtier.

16. Procédé selon une des revendications 10 à 15, **caractérisé en ce que** la au moins une tige de contact (8.1,8.2) est soudée conjointement avec les composants électriques sur la plaquette de circuit au cours d'une seule opération.
